# EUROPEAN PATENT SPECIFICATION

(11) **EP 2 394 154 B1**
(45) Date of publication and mention of the grant of the patent: **04.04.2018**
(21) Application number: 10704005.7
(22) Date of filing: 03.02.2010
(51) Int. Cl.: G01N 21/25, G01N 21/64, G01N 21/77, H01L 25/04, H01L 27/28

(54) **ORIGAMI SENSOR**
ORIGAMI-SENSOR
CAPTEUR ORIGAMI

(30) Priority: 04.02.2009 EP 09152056
(43) Date of publication of application: 14.12.2011
(73) Proprietor: Nederlandse Organisatie voor toegepast- natuurwetenschappelijk onderzoek TNO, 2595 DA 's-Gravenhage (NL)
(72) Inventor: ALLARD, Bart A.M., NL-5995 AD Kessel (NL); SHARPE, Ruben Bernardus Alfred, NL-2651 PC Berkel en Rodenrijs (NL)
(74) Representative: V.O.
(86) International application number: PCT/NL2010/050048
(87) International publication number: WO 2010/090519

(56) References cited:
- GB-A- 1 353 776
- US-A- 5 015 843
- US-A1- 2007 102 654
- US-A1- 2008 258 086
- KRAKER ELKE ET AL: "Integrated organic electronic based optochemical sensors using polarization filters" APPLIED PHYSICS LETTERS, AIP, AMERICAN INSTITUTE OF PHYSICS, MELVILLE, NY, US LNKD- DOI:10.1063/1.2837410, vol. 92, no. 3, 23 January 2008 (2008-01-23), pages 33302-33302, XP012107887 ISSN: 0003-6951
- YUN SHUAI ET AL: "On-Chip Fluorescence Detection Using Organic Thin Film Devices for a Disposable Lab-on-a-Chip" UNIVERSITY/GOVERNMENT/INDUSTRY MICRO/NANO SYMPOSIUM, 2008. UGIM 2008. 17TH BIENNIAL, IEEE, PISCATAWAY, NJ, USA, 13 July 2008 (2008-07-13), pages 169-172, XP031289976 ISBN: 978-1-4244-2484-9

## Description

The invention relates to an optical sensor, in particular to manufacturing optical sensors on a flexible foil.

In a typical optical sensor, light has to travel from a light emitting source, through some light guiding medium to a light receiving detector. To increase the measurement accuracy and reliability of optical sensors, it is desired to manufacture arrays of optical sensors instead of a single sensor. This may be done by printing organic light emitting diodes (OLED's) and organic photodiodes (OPD's) on a flexible foil. To decrease the production time and assembly costs the printing is preferably done in a roll-to-roll process.

However, both OLED's and OPD's are pseudo two-dimensional and can normally interact only when facing each other. The archetypal sensor configuration is therefore a layered structure with a separate layer for each of the electro-optical components and for the guiding element sandwiched between them. Assembling a sensor configuration like this by e.g. laminating and interconnecting electronic foils may be difficult in a roll-to-roll process.

One way to reduce the complexity involved with assembling the optical sensor is to manufacture both the OLED's and the OPD's in the same foil. This eliminates one layer from the archetypal optical sensor as described above. Guiding elements are positioned on the foil to guide the light from the OLED's to the OPD's. US Patent Application Publication 2007/0102654 A1 shows an example of this approach. Unfortunately, accurate positioning of the light guiding elements on the foil makes this sensor configuration unsuitable for use in a roll-to-roll process. Furthermore, positioning light guiding elements on planar optical elements while retaining sufficient reflectivity may be difficult.

An article in Appl. Phys. Lett. 92, 033302 (2008) by Kraker et al. shows an integrated optochemical sensor that uses two polarization filters to separate emission and excitation light.

U.S. Patent 1,353,776 by Elliott, which is directed to an apparatus for indicating a change in an ambient condition, discloses in one of its embodiments folding a polarizing material at 45 degrees to its polarizing axis to form two leaves whose polarizing axes are at right angles to one another. US Patent Application Publication 2008/0258086 A1 shows an optical detector wherein a substrate is folded over at a flexible part through 180 degrees. At the top, the substrate supports a vertical emitting laser device while at the lower branch the substrate supports an integrated circuit photo-diode array sensor.

It is an object of the present invention to provide an optical sensor configuration compatible with roll-to-roll manufacturing.

In one aspect, the invention, as defined in appended independent claim 1, provides an optical sensor comprising a flexible substrate and an optical element being positioned on the substrate. The flexible substrate comprises least one deformation affecting the optical element. The at least one deformation is provided in a substrate deformation zone at least partly surrounding the optical element.

### Figures

Figure 1: Exemplary embodiment of the optical sensor according to the present invention, showing deformations provided in a substrate deformation zone at least partly surrounding the optical element.
Figure 2: Exemplary embodiment of the optical sensor according to the present invention, wherein the deformation zone is at least partially weakened.
Figure 3: Exemplary embodiment of the optical sensor according to the present invention, wherein the deformation zone is at least partially disconnected.
Figure 4: Top view of a deformation zone in an optical sensor according to the present invention.
Figure 5: Exemplary embodiment of the optical sensor according to the present invention.
Figure 6: Section view of an exemplary stack of a single organic optical element.
Figure 7: Section view of a source and detector pair.
Figure 8: Exemplary embodiments of the optical sensor according to the present invention.
Figure 9: Exemplary embodiments of the optical sensor according to the present invention.
Figure 10: Exemplary embodiment of the optical sensor according to the present invention comprising a light guiding element.
Figure 11: Exemplary embodiment of the optical sensor according to the present invention, wherein the sensor active material changes the shape and/or size of the light guiding element.
Figure 12: Exemplary embodiment of the optical sensor according to the present invention, wherein the substrate forms a polarization filter.
Figure 13: Exemplary embodiment of the optical sensor according to the present invention, wherein the substrate is partially doubled.
Figure 14: Exemplary embodiment of the optical sensor according to the present invention, wherein the light guiding element is a complete layer.
Figure 15: Exemplary sensor arrays.
Figure 16: Schematic representation of a complete sensor.

The present invention will become more readily apparent from the following detailed description of the preferred embodiments of the present invention taken in conjunction with the accompanying drawings.

### Detailed description of the embodiments

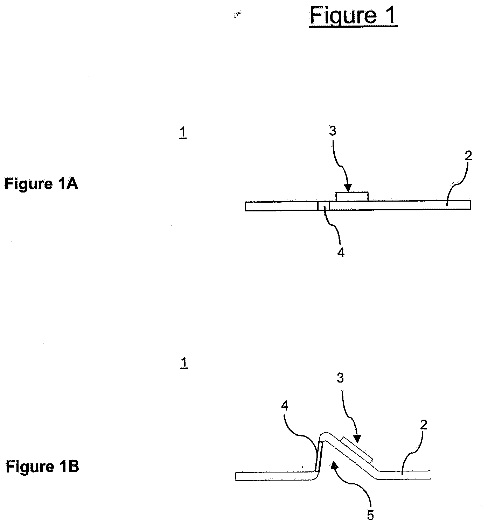

FIG. 1A schematically shows a first production stage of an exemplary embodiment of the optical sensor according to the present invention, before the deformations 5 have been provided in the substrate 2. The sensor 1 comprises a flexible substrate 2 and optical element 3 being positioned on the substrate 2. The substrate 2 comprises deformation zone 4.

The optical sensor in its complete form is schematically shown in FIG. 1B, wherein the flexible substrate 2 comprises deformation 5 affecting at least one of the optical element. Typically, only the substrate 2 may be deformed and the optical elements 3 are not deformed. The deformations 5 are provided in a substrate deformation zone 4 at least partly surrounding the optical element. The deformations 5, e.g. bending or folding may be effected by such techniques as, but not limited to moulding or embossing.

Preferably, the substrate 2 is completely flexible in both the rolling direction and the direction transverse to the rolling direction. However, a substrate 2 that is flexible in the rolling direction only may be compatible with roll-to-roll manufacturing.

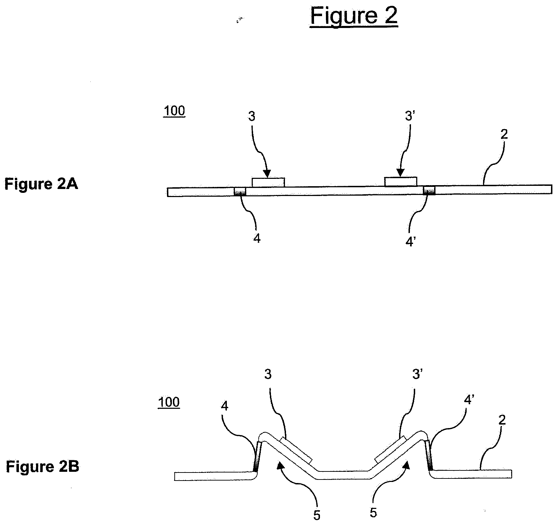

To ease the deformation 5 of the substrate 2, the substrate deformation zone 4 may be at least partly weakened or at least partly disconnected from the substrate 2. FIG. 2 shows an embodiment 100 of the sensor according to the present invention, wherein the substrate deformation zone 4 is weakened. FIGS. 2A and 2B show an embodiment of the optical sensor in a first production stage and in its complete form respectively. FIG. 2 shows two optical elements 3 and 3'. The weakened deformation zones 4 and 4' may e.g. be manufactured by providing weakened spots in the substrate 2. Local weakening may be effected by such methods as, but not limited to, ablation, milling or the local application of solvents or heat. Providing a weakened zone around the optical elements 3 or partly disconnecting the optical elements 3 may also ease the repositioning of the optical element.

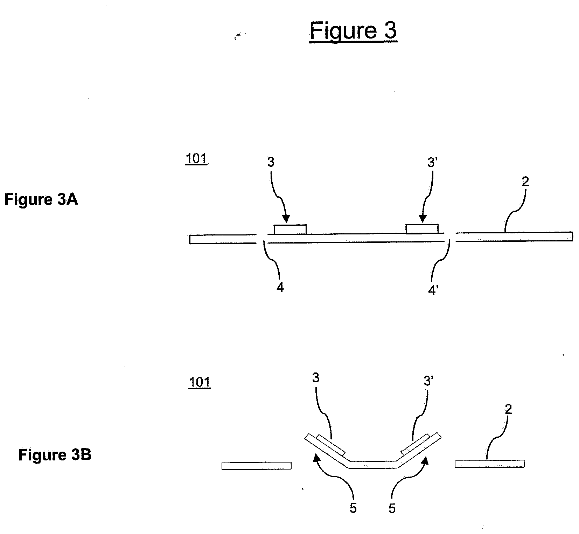

In FIG. 3 an embodiment 101 of the sensor is shown similar to embodiment 100, but wherein the substrate deformation zone 4 is at least partly disconnected from the substrate 2. FIG. 3A shows a first production stage of this embodiment of the optical sensor and FIG. 3B shows the complete sensor. Partial disconnection may be effected by such methods as, but not limited to, cutting, milling or drilling. Within the scope of the appended claims, the direction of the cut or weakening zone may be arbitrarily chosen, thus allowing freedom of the orientation with respect to the substrate 2 and with respect to each other. This may enable optical configurations that are not easily attainable otherwise.

The flexibility of the substrate 2 may be used to overcome some geometrical constrains posed by the roll-to-roll process, e.g. by reshaping the substrate 2 after the critical processing steps. In particular, during roll-to-roll processing, the substrate 2 is preferably flat and flexible. After the critical processing of the sensor devices, the optical elements 3 may be partly disconnected from the substrate 2 and the flexibility may be used for repositioning the optical elements 3.

Surrounding the optical elements 3 at least partially by a zone wherein the substrate 2 is weakened or partially disconnecting the substrate 2 increases the freedom of design with respect to the optical element configuration.

The substrate 2 is preferably made of transparent plastic foils such as polyethylenenaphthalate or polyethyleneterephthalate. However it is also possible to use other, non-transparent materials, such as metal foils. The optical elements 3 may be build-up using various architectures and materials.

In the optical sensor according to the present invention, an optical element may be a light emitting source , a light receiving detector or a light guiding element.

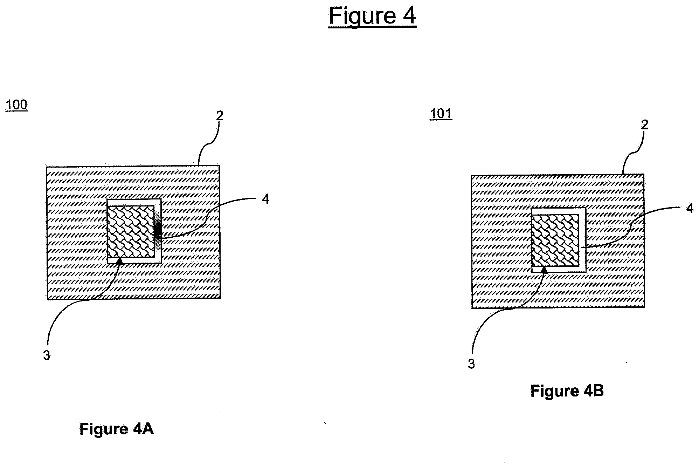

FIG. 4 shows a top view of one optical element of the two embodiments of the sensor as described in FIGS. 2 and 3. FIG. 4A illustrates a top view of sensor with a substrate deformation zone 4, wherein the deformation zone is at least partly weakened and surrounds the element 3. FIG. 4B illustrates a top view of sensor, wherein the substrate deformation zone 4 is at least partly disconnected from the substrate 2. In the embodiments disclosed in the specification it is shown that at least partly surrounding involves a weakening or cut that extends along a contour directly adjacent the optical element. The contour extends in a least two different directions, preferably along three of four sides of the optical element 3. The weakening zone is close enough to affect the optical function, yet distant enough to not compromise the elements.

In the embodiments 100 and 101 as shown in FIGS. 2, 3 and 4, the affected optical elements 3 may be a light emitting source and a light receiving detector. A source and detector pair may be used for detecting, measuring or analyzing a medium that is applied in between. In some cases, e.g. for chemical sensors, it is preferred to elaborate the source and the detector with an optical waveguide in between the source and detector. The waveguide may function as a sensing active material or the waveguide could comprises a sensor active material.

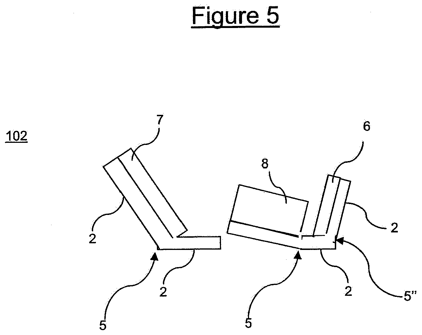

FIG. 5 shows an embodiment 102 of the optical sensor according to the present invention comprising a light emitting source 6, a light receiving detector 7 and a light guiding element 8. In this embodiment, also the light guiding element 8 is partly disconnected from the surface and affected by a deformation 5 of the substrate 2.

In one embodiment, the light emitting source 6 may comprise an organic light emitting diode (OLED) or a small molecule organic light emitting diode (SMOLED). The light receiving detector 7 may comprise an organic photo diode (OPD) or a small molecule organic photo diode (SMOPD).

It is preferred to use non contact printing techniques to deposit the organic materials on the substrate 2 to prevent contamination of the materials. Nevertheless contact coating techniques may be used, e.g. when the optical elements 3 are processed on both sides of the substrate 2 or when a layer with certain functionality is protected by a barrier layer before printing another functional layer on top of this layer.

Furthermore foils with certain functionality may be laminated together. With printed, stacked or laminated optical elements 3 it is possible to use OLED's with different wavelengths by using different light emitting polymer materials. The single optical elements 3 are preferably encapsulated with transparent and flexible barrier layers to protect them against moisture.

In case it is desired to eliminate wave guiding through the foil, optical elements 3 may be fabricated that emit and receive light on the top side. The light only has to be guided through the thin layers on top of the organic semiconducting polymer. These layers are very thin in comparison with the flexible substrate 2 and therewith reduce internal guiding of light through the stacked layers. In the state of art these elements are called top-emissive- elements.

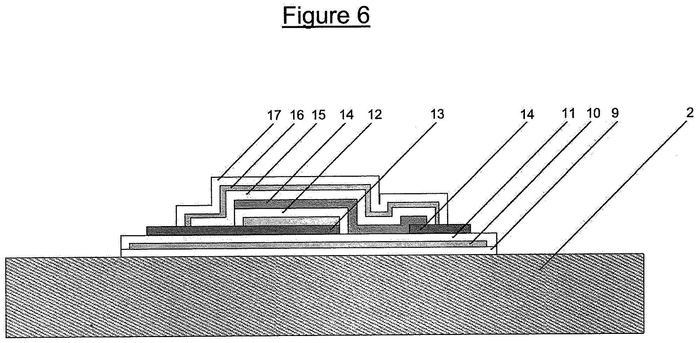

FIG. 6 shows a section view for a possible configuration of a single organic optical element. A patterned moisture resistive ceramic-like layer 9 is deposited on a flexible substrate 2. On top of the moisture resistive ceramic-like layer 9, an organic layer 10 is applied to increase the diffusion length path for moisture. The organic layer 10 may also be patterned but somewhat smaller in size. The organic layer 10 may be covered with a patterned ceramic layer 11 which is impermeable to moisture. The shape of patterned ceramic layer 11 preferably covers the organic layer 10. These layers finalize the barrier stack on the flexible substrate 2.

The active organic optical elements 3 applied on top of the barrier stack comprise a patterned organic light emitting or receptive material 12 sandwiched between a patterned anode 13 and a patterned cathode 14. The contact for the cathode 14 is the same material as the anode 13 material to prevent degradation of the cathode 14 by oxygen and moisture.

The electrically active organic layers may be protected from moisture by a patterned encapsulation, comprising a patterned ceramic layer 15, a patterned organic layer 16, preferably smaller in size than the patterned ceramic layer 15 to increase the diffusion length path for moisture and a ceramic layer 17 preferably as large as patterned ceramic layer 15.

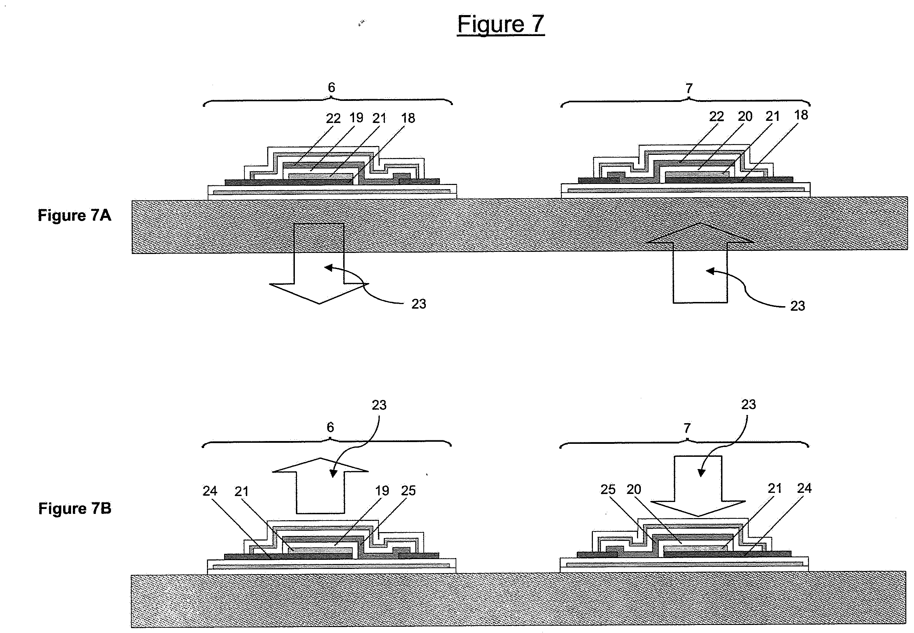

The optical element may be bottom-emissive or top-emissive. FIG. 7A shows a possible configuration for a couple of bottom-emissive organic optical elements 3, a light emitting source 6 and a light receiving detector 7. Both the source 6 and the detector 7 comprise a patterned barrier stack, a patterned transparent anode 18, e.g. made from Indium doped TinOxide (ITO), patterned light emitting polymer 19 or light receiving polymer 20, a patterned transport layer for holes 21 and a patterned reflective metal cathode 22. The device is encapsulated with a patterned barrier stack against moisture and oxygen. In case of bottom-emissive optical elements 3 as shown in FIG. 7A, the cathode 22 is reflective and light 23 is emitted resp. received through the barrier on the substrate 2 and the substrate 2 itself. For bottom-emissive optical elements 3 the substrate 2, the barrier on the substrate 2, the anode 18 and the whole transport layer 21 are transparent.

In top-emissive organic optical elements 3, as shown in FIG. 7B, the source 6 and detector 7 comprise a patterned barrier stack, a patterned reflective metal layer as anode material 24, a patterned hole transport layer 21, a patterned light emitting 19 or receiving 20 polymer, and a patterned thin transparent metal layer 25 as cathode material for electron injection. In case of top-emissive devices the anode 24 is reflective and the light 23 is emitted resp. received through a transparent cathode 25 and the transparent encapsulation.

A special characteristic of this stack design is that inorganic barrier layers are provided such that they completely encapsulate the individual organic elements. Therefore, separating the individual elements by a weakening zone or a disconnection, e.g. by laser, does not expose the organic element to the environment. Thus the organic optical element is protected from moisture entering the element in the cutting or weakening zone. Contact with moisture typically reduces the lifetime of organic elements and is therefore undesired.

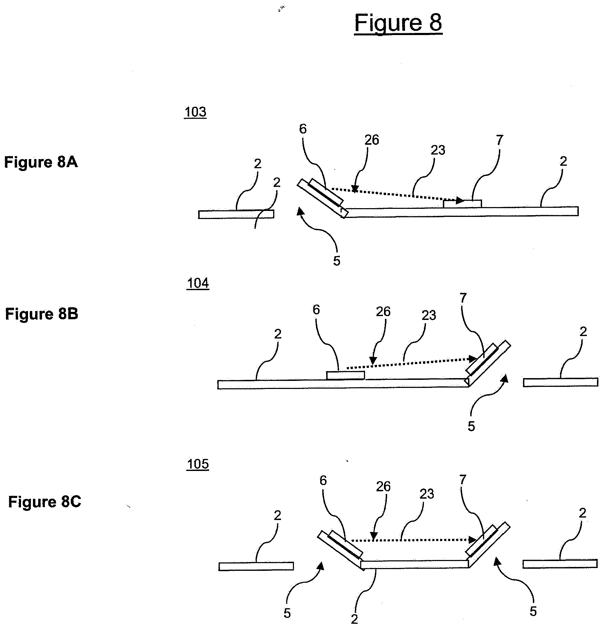

FIG. 8 illustrates three other embodiments of the optical sensor according to the present invention, wherein the sensor comprises a light emitting source 6 and a light receiving detector 7 being positioned on the substrate 2. The detector 7 is responsive to the light 23 emitted by the source 6. The deformations 5 of the substrate 2 are arranged to tilt at least one of the source 6 and the detector 7 to provide a light path 26 for light travelling from the source 6 to the detector 7.

FIG. 8A shows an embodiment 103, wherein the deformations 5 of the substrate 2 are arranged to tilt the light emitting source 6 to provide a light path 26 for light 23 travelling from the source 6 to the detector 7. FIG. 8B shows an embodiment 104, wherein the deformations 5 of the substrate 2 are arranged to provide a light path 26 for light 23 travelling from the source 6 to the detector 7. FIG. 8C shows embodiment, wherein the deformations 5 of the substrate 2 are arranged to tilt both the light emitting source 6 and the light receiving detector 7 to provide a light path 26 for light 23 travelling from the source 6 to the detector 7.

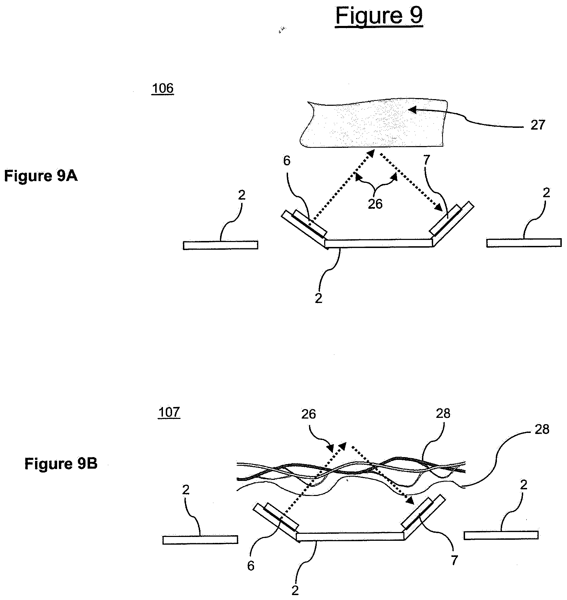

FIG. 9 illustrates an embodiment 106 of the present invention, wherein a source 6 and detector 7 pair may sense the presence of a medium 27. FIG. 9A illustrates how the light 26 from the source 6 may be reflected or absorbed by the medium 27, whereby the amount of reflection characterizes the medium 27. FIG. 9B schematically shows an embodiment 107, wherein the medium 27 comprises the skin 28 of a human or of an animal. This embodiment of the sensor may be used in smart bandages for measurements in or on the body. The light may be more or less absorbed depending on the amount and capacity of the blood in the capillaries or veins 28. Due to the repositioned optical elements 3, a two dimensional architecture is created. A two dimensional architecture may have the advantage, compared to a planar architecture that it may prevent capillaries to close when the sensor is slightly pressed on the skin.

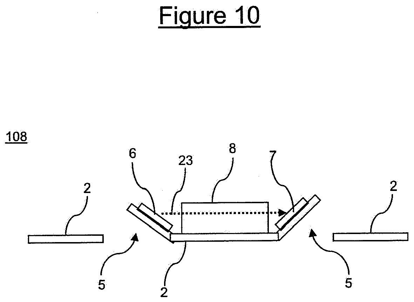

In yet another embodiment 108 of the optical sensor according to the present invention, illustrated in FIG. 10 and based on sensor 105 shown in FIG. 8C, the sensor further comprises a light guiding element 8. The light guiding element 8 may be applied with techniques such as, but not limited to printing, embossing or moulding. The light guiding element 8 may be directly printed onto, embossed into or moulded on the substrate 2 with optical elements 3. Alternatively the light guiding element 8 could be fabricated separately using injection moulding or embossing techniques. In this embodiment, the light guiding element 8 is positioned at least partially between the source 6 and the detector 7. The light guiding element 8 comprises a sensor active material being sensitive to the amount of analyte in a fluid. The term fluid is to be construed as a collective term for gasses and liquids surrounding the sensor. Alternatively, the waveguide itself may be composed of the sensor active material.

The weakening zone enables bending the organic optical elements 3 against or around the light guiding element 8 so as to optimally position the optical elements 3 with respect to the sensing structure.

In another embodiment, the sensor active material changes the light guiding properties, e.g. the absorption characteristics of the light guiding element 8, depending on the amount of certain analyte molecules in a fluid surrounding the sensor. Changes in the light that is transmitted through the light guiding element 8 may be measured by the detector 7, e.g. the photodiode.

In one embodiment, the optical sensor according to the present invention, the sensor active material changes the reflective properties of the light guiding element 8, depending on the amount of analyte in the fluid surrounding the sensor.

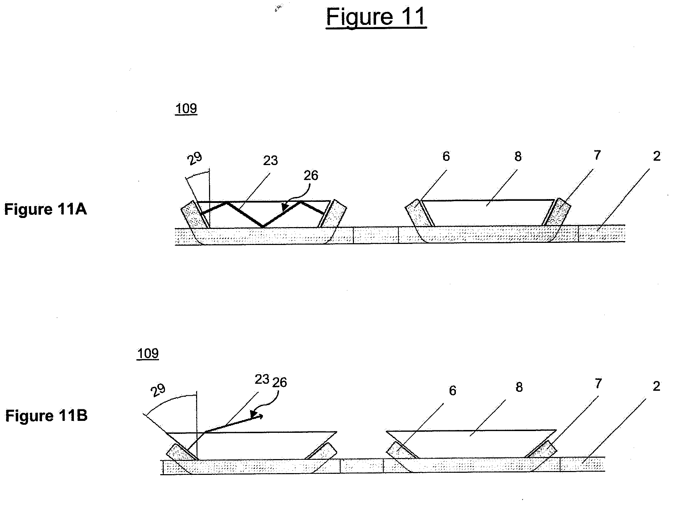

In the embodiment 109, illustrated in FIG. 11 and based on sensor 105 shown in FIG. 8C, the light emitting source 6 and the light receiving detector 7 are abutted the light guiding element 8, and the sensor active material changes the shape and/or size of the light guiding element 8 depending on the amount of analyte in the fluid surrounding the sensor so as to change a tilting angle 29 of the light emitting source 6 and/or the light receiving detector 7.

Changes in the volume of the sensor active material, induced by the presence of the analyte, may contribute to changes of its optical properties. The volume change may also be used to mechanically induce changes in the tilting angle of the source 6 and/or the detector 7, thereby changing the alignment of the optical elements 3. Also the volume change may cause a variation in the thickness of the guiding structure. These changes in optical properties, as well as the induced change in the optical geometry, influence the transport of light through the waveguide.

With the above described architecture it becomes possible to combine both changes in colour and changes in volume to create more sensitive or more selective sensors. For example one source 6 and detector 7 pair, able to bend whereby the substrate 2 acts like a hinge, may measure the differences in reflected light due to the changing optical geometry while a pair of optical elements 3 with a fixed position may measure the changes in colour.

FIG. 11A shows sensor 109 while not exposed to a fluid comprising an amount of analyte. In this state, there is a certain tilting angle between device and the guiding element 8. In the state wherein sensor 109 is exposed to a fluid comprising an amount of analyte, as shown in FIG. 11B, the size and/or shape of the light guiding element 8 have changed and therewith the tilting angle. The change in angle results in a change of reflective properties of the light guiding element 8 and therefore changes the light path 26.

For transporting the analyte to the sensor active material, the light guiding element 8 may comprise a fluidic transport system. Typically, the stratum of the sensor active material includes an open structure for the transport of liquids or gasses, e.g. micro fluid channels. A fluidic transport system may allow for sufficient contact between the sensor active material and the analyte.

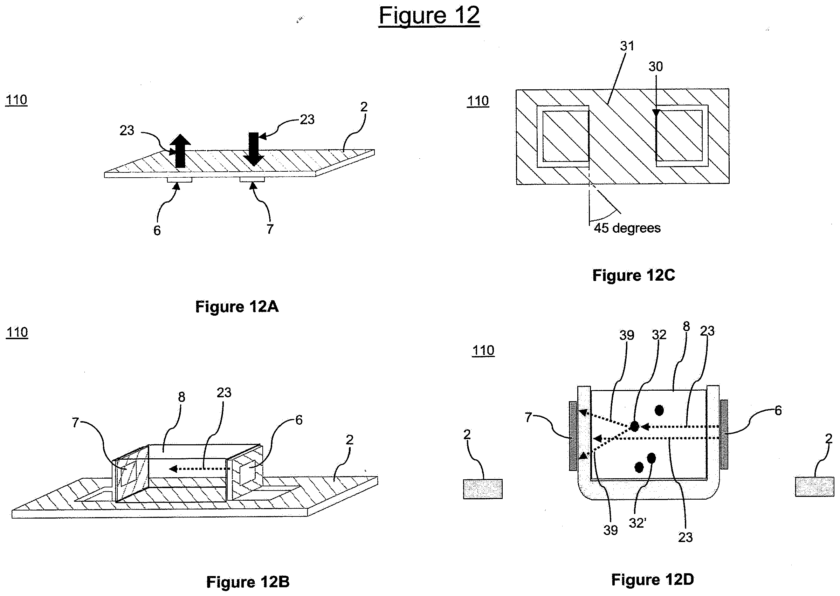

Another embodiment 110 is illustrated in FIG. 12. In this embodiment, the optically effective substrate 2 forms a polarization filter. A first production stage of this embodiment is shown in FIG. 12A. Sensor 110 comprises a light emitting source 6 and a light receiving detector 7 being positioned on the substrate 2. The source 6 and the detector 7 comprise an optical surface. With optical surface, a surface of the light emitting source 6, e.g. an OLED is meant wherein the light is coupled out of the source 6. For a light receiving detector 7, e.g. an OPD, the optical surface is the surface wherein the light is received. The substrate 2 is an optically effective substrate 2. Optically effective means that the substrate 2 comprises optical functionality, e.g. polarization functionality. However, other optical functionalities, such as a colour filter are also possible. The optical surface of the source 6 and the detector 7 are directed towards the optically effective substrate 2. Therefore, the light emitted by the source 6 travels through the optically effective substrate 2 and the light is received by the detector 7 through the optically effective substrate 2.

FIG. 12B shows the complete sensor wherein a light guiding element 8 is positioned at least partly between the source 6 and the detector 7. The light guiding element 8 comprises luminescent dyes 32 emitting luminescence light 39 with a random polarization when optically activated. The characteristics of the luminescence light 39 depend on the amount of analyte in the fluid surrounding the sensor. Light that travels from the source 6 through the light guiding element 8 to the detector 7 is linearly polarized first by a part of the polarization filter whereupon the source 6 is positioned and linearly polarized second by a part of the substrate 2 whereupon the detector 7 is positioned, the second polarization being turned for 90 degrees with respect to the first polarization. The linearly polarized light 23 travels through the light guiding element 8 and activates the luminescent dyes 32 to emit luminescence light 39 with a random polarization. The detector 7 receives the characteristics of the part of the luminescence light 39 with the random polarization. Linearly polarized light which had no contact with luminescent dyes 32 will be blocked by the 90 degree turned polarization and will not receive the detector 7. From the signal of the detector 7, the amount of analyte in the fluid surrounding the sensor may be determined.

FIG. 12C shows that the optical sensor may obtain 90 degrees rotation in polarization direction by positioning the bending line 30 of the source 6 and the detector 7 45 degrees rotated with respect to the polarization direction of the substrate 31.

FIG. 12D schematically presents a section view of the complete embodiment as shown in FIG. 12B.

The light guiding element 8 may comprise a fluidic transport system for transporting the analyte to the luminescent dyes.

The use a flexible substrate 2 may also be advantageous in architectures wherein at least one optical element on the flexible substrate 2 is partially disconnected and folded back to the substrate 2, so as to partially double the substrate 2. Before the substrate 2 is doubled, the optical surface may be directed away from the substrate 2. After doubling the substrate 2, the optical surface is redirected towards the substrate 2 which makes it possible to use a flexible substrate 2 with an optical function.

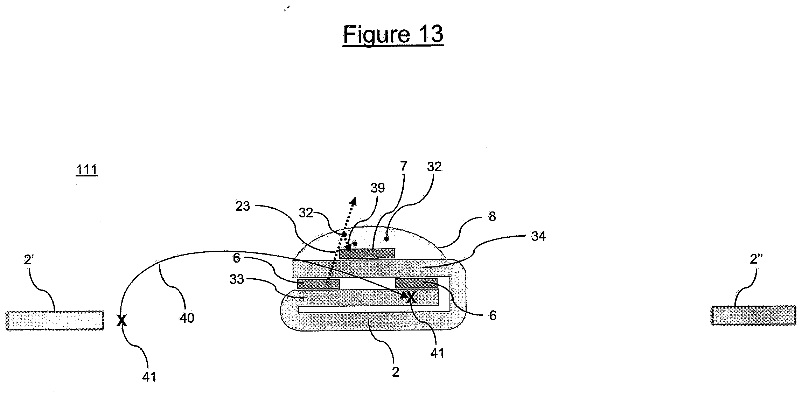

FIG. 13 shows a section view of embodiment 111. This embodiment is an exemplary architecture of a partially doubled substrate 2 wherein the substrate 2 has polarization functionality. A first part of the substrate 33 whereupon the sources 6 are fabricated after being dissected from substrate 2' (substrate 2' is shown on the left), is folded back to the substrate 2. The arrow 40 indicates the movement of a part of the substrate X 41 due to folding. A second part of the substrate 34 whereupon the detector is fabricated after being dissected from substrate 2" (substrate 2" is shown on the right), is folded back and positioned on top of the sources 6, so as to linearly polarize the light 23 from the sources 6. For the second part 34, for clarity, the movement is not indicated. On top of the partially doubled substrates 2 a guiding element 8 may be applied which may comprise luminescent dyes 32.

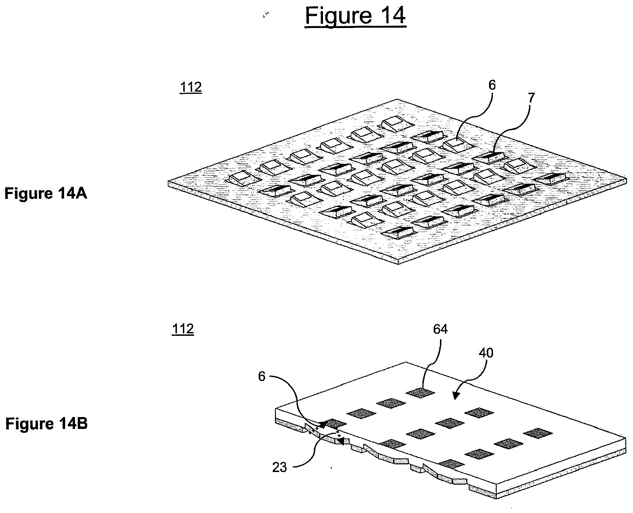

The linearly polarized light 23 travels through the light guiding element 8 and activates the luminescent dyes 32 to emit luminescence light 39 with a random polarization. The detector 7 receives the characteristics of the part of the luminescence light 39 with the random polarization. From the detector signal, the amount of analyte in the fluid surrounding the sensor may be determined. The linearly polarized light 23 which had no contact with the luminescent dyes 32 is coupled out of the light guiding element 8 without being registered by the detector 7. It is emphasized that although FIG. 13 shows a section view of a single sensor node, the sensor node is likely to be part of a sensor array similar to the sensor arrays shown in FIGS. 14, 15 and 16.

Further, partially doubling the substrate 2 may provide a light guiding element 8 in which internal light reflections are captured.

FIG. 14 schematically illustrates a pseudo in-plane optical sensor array 112. FIG. 14A shows a first production stage of the array, comprising couples of partly disconnected sources 6 and detectors 7 which are repositioned out of plane in a predefined position.

The complete sensor array is shown in the section view of FIG. 14B. It can be seen that a full layer of material for light guiding purposes is applied on top of the substrate 2 whereupon the array of sources 6 and detectors 7 are produced. The emitted light from sources 6 is guided through the optical guiding layer and reaches the sensing material 64. The sensing material will influence the light 23 that will be received by the detector 7.

Using a complete layer as a light guiding element 8 may avoid problems with attaching optical elements 3, e.g. the problems of displacement. The light guiding material may comprise sensing materials or components, or the sensing material or components may be deposited on top of the optical guiding layer. The sensing material or component may also be deposited on top of the optical element 40.

One way of manufacturing sensor array 112 is to apply the light guiding layer on top of the complete substrate 2 area with the optical elements 3 already positioned, with techniques such as printing, injection moulding or coating, but not limited thereto. A manufacturing variation is to coat the light guiding material before the source 6 and detector are formed in the predefined position. The optical elements 3 must be deformed before the layer on top will be hardened. The optical elements 3 may be partly disconnected and embossed in the light guiding layer.

In some applications, such as a bandage comprising an array of sources 6 and detectors 7, a transparent light guiding layer may only function as protection layer instead of sensing layer.

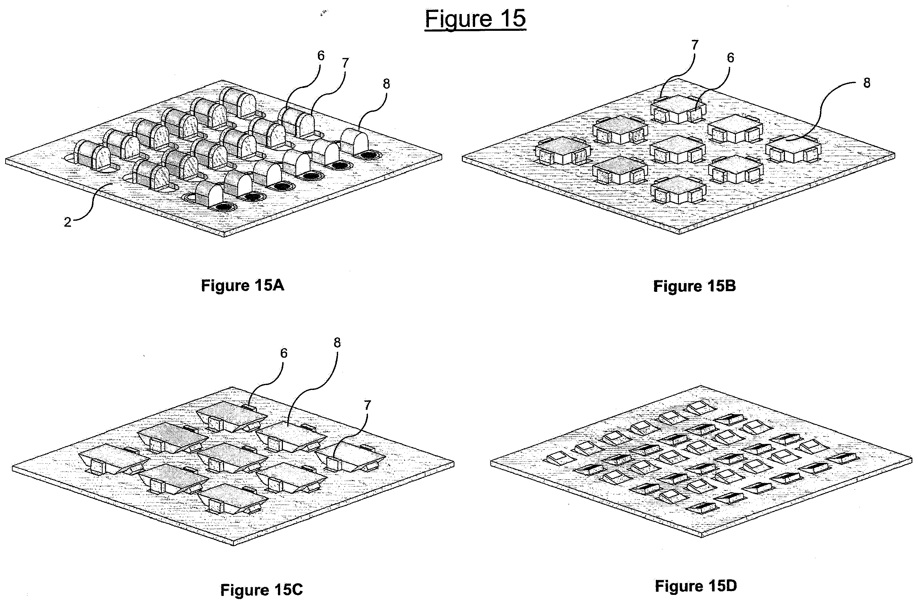

FIG. 15 shows four optical sensor arrays according to a variety of sensor nodes as described above. Up to now, only the configuration of single sensor node has been described, isolated from the complete optical sensor system. The sensor arrays in FIG. 15A, 15B and 15C comprise an array of transmissive or reflective sensor nodes, based on flexible substrates 2 with light emitting sources 6 and light receiving detectors 7, complemented with a light guiding medium in between. To finalize these sensor arrays the source 6 and detector are bended against the light guiding element 8. Using an array of sensors nodes instead of a single measuring node may improve the quality and reliability of an optical sensor. Each sensor node or groups of sensor nodes could e.g. be configured with source 6 and detector pairs sensitive to different wavelengths of light.

To prevent crosstalk in a sensor array, each source 6 detector pair may have its own guiding element 8. Crosstalk is the phenomenon that the detectors 7 unintentionally receive light from neighbouring sensor elements because of imperfect optical isolation.

FIG. 15A shows an example of a sensor array comprising the sensor node 108 as shown in FIG. 10. After applying the optical waveguide the planar source 6 and detector are bended against the waveguide.

FIG. 15B shows an example of a sensor array whereby the direction of the cut of weakening zone is arbitrary chosen to show the complete freedom of the bended devices. This design is not easily attainable otherwise.

FIG. 15C shows a schematic configuration where both changes in adsorption and changes in volume are combined. One pair of source 6 and detector has a fixed position, the other pair of source 6 and detector is able to bend whereby the substrate 2 functions as a hinge as described for sensor node 109 shown in FIG. 11.

FIG. 15D shows an example of an optical sensor array without optical guiding systems as explained for embodiment 112 in FIG. 14.

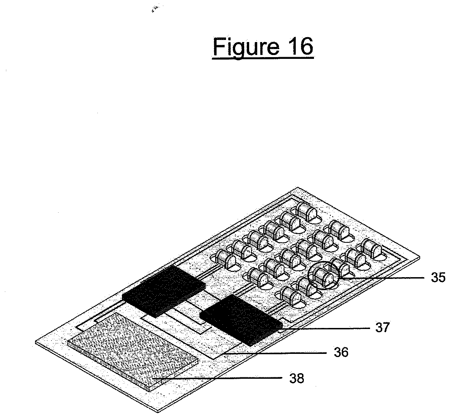

FIG. 16 illustrates a complete optical sensor system, comprising an array of sensor nodes 35, a printed circuit 36, electronic components 37 and a battery 38. Since the manufacturing method of the sensors may leave the planar substrate 2 largely intact, the sensor array may easily be connected to a conventional (flexible) printed circuit board (F)PCB. Conversely, the substrate itself may be used as an alternative for the printed circuit board. Also moulded interconnect devices (MID) may be used whereby both the optical members and the PCB, are fabricated with the moulding technique.

The foil with the electro-optical elements 3 may be laminated to the separately produced sensor active optical element. This optical element comprises the sensing material, a matrix or substrate material that has been optimized for optical sensing with respect to e.g. its optical conductance and its permeability for the analyte, and auxiliary elements such as mirrors or gratings applied preferably with, but not limited to printing, coating or embossing techniques.

The detailed drawings, specific examples and particular formulations given serve the purpose of illustration only. Since the many layers of the OLED-stack may cause internal optical interference, the light output profile of an OLED may depend on the viewing angle. In this light, the deformations of the substrate may be arranged to tilt at least one of the source and the detector to direct a dominant light emitting direction of a light emitting profile of the source to the detector or to direct a dominant light receiving direction of a light receiving profile of the detector to the source. The dominant direction of the light emitting profile of an OLED may for example be at an angle of approximately 45° with respect to the optical surface of the OLED. Similar considerations apply to a light receiving detector comprising an organic photo diode (OPD) or another kind of organic electro-active material. The OPD or SMOPD may have a dominant light receiving direction in a light receiving profile at a certain angle, e.g. an angle of 45° with respect to the optical surface of the OPD or SMOPD. Other substitutions, modifications, changes, and omissions may be made in the design, operating conditions, and arrangement of the exemplary embodiments without departing from the scope of the invention as expressed in the appended claims.

## Claims

1. An optical sensor (1), the sensor comprising:
- a flexible substrate (2),
- an optical element (3) being positioned on the substrate (2), the flexible substrate (2) comprising a deformation (5) affecting the optical element (3),
- **characterized in that** the deformation (5) is provided in a substrate deformation zone (4) at least partly surrounding the optical element (3) along a contour directly adjacent the optical element (3); the contour extending in a least two different directions along the optical element (3).

2. The optical sensor according to claim 1, wherein the substrate deformation zone (4) is at least partly weakened or at least partly disconnected from the substrate (2), so as to ease the deformation of the substrate (2).

3. The optical sensor according to claim 1, wherein the optical element (3) is from a group of a light emitting source (6), a light receiving detector (7) and a light guiding element (8).

4. The optical sensor according to claim 3, wherein the light emitting source (6) comprises an organic light emitting diode or a small molecule organic light emitting diode.

5. The optical sensor according to claim 3, wherein the light receiving detector (7) comprises an organic photo diode or a small molecule organic photo diode.

6. The optical sensor according to claim 1, wherein
- the sensor comprises two optical elements (3) comprising a light emitting source (6) and a light receiving detector (7) positioned on the substrate (2), the detector being responsive to the light (23) emitted by the source (6), and
- wherein the deformation (5) of the substrate (2) is arranged to tilt the light emitting source (6) or the light receiving detector (7) to provide a light path (26) for light (23) travelling from the source (6) to the detector (7), or
wherein the optical sensor comprises a first deformation (5) arranged to tilt the light emitting source (6) and a second deformation (5) arranged to tilt the light receiving detector (7) to provide a light path (26) for light (23) travelling from the source (6) to the detector (7).

7. The optical sensor according to claim 6, wherein the sensor further comprises a light guiding element (8), the light guiding element (8) being positioned at least partially between the source (6) and the detector (7), wherein the light guiding element (8) comprises a sensor active material being sensitive to the amount of analyte in a fluid surrounding the sensor.

8. The optical sensor according to claim 7, wherein the sensor active material changes the light guiding properties of the light guiding element (8) depending on the amount of analyte in a fluid surrounding the sensor.

9. The optical sensor according to claim 8, wherein the sensor active material changes the reflective properties of the light guiding element (8), depending on the amount of analyte in the fluid surrounding the sensor.

10. The optical sensor according to claim 8, wherein the at least one of the light emitting source (6) and the light receiving detector (7) is abutted the light guiding element (8), and wherein the sensor active material changes the shape and/or size of the light guiding element (8) depending on the amount of analyte in the fluid surrounding the sensor, so as to change a tilting angle of the light emitting source (6) and/or the light receiving detector (7).

11. The optical sensor according to any one of claims 7 - 10, wherein the light guiding element (8) comprises a fluidic transport system for transporting the analyte to the sensor active material.

12. The optical sensor according to claim 6, wherein an optical surface of at least one of the source (6) and the detector (7) is directed towards the substrate (2), which is optically effective.

13. The optical sensor according to claim 12, wherein the optically effective substrate (2) forms a polarization filter.

14. The optical sensor according to claim 13, wherein
- a light guiding element (8) is positioned at least partly between the source (6) and the detector (7),
- the light guiding element (8) comprises luminescent dyes (32) emitting luminescence light (39) with a random polarization when optically activated, the characteristics of the luminescence light (39) depending on the amount of analyte in the fluid surrounding the sensor.

## Patentansprüche

1. Optischer Sensor (1), der Sensor umfassend:
- ein flexibles Substrat (2),
- ein optisches Element (3), positioniert auf dem Substrat (2), das flexible Substrat (2) umfassend eine Deformation (5), die sich auf das optische Element (3) auswirkt,
- **dadurch gekennzeichnet, dass** die Deformation (5) in einer Substratdeformationszone (4) bereitgestellt ist, die das optische Element (3) entlang einer Kontur direkt neben dem optischen Element (3) mindestens teilweise umgibt, welche Kontur in mindestens zwei verschiedene Richtungen entlang des optischen Elements (3) verläuft.

2. Optischer Sensor nach Anspruch 1, wobei die Substratdeformationszone (4) mindestens teilweise geschwächt oder mindestens teilweise von dem Substrat (2) getrennt ist, um die Deformation des Substrats (2) zu erleichtern.

3. Optischer Sensor nach Anspruch 1, wobei das optische Element (3) von einer Gruppe von einer Licht emittierenden Quelle (6), einem Licht empfangenden Detektor (7) und einem Licht leitenden Element (8) ist.

4. Optischer Sensor nach Anspruch 3, wobei die Licht emittierende Quelle (6) eine organische Licht emittierende Diode oder eine organische Licht emittierende Kleinmoleküldiode umfasst.

5. Optischer Sensor nach Anspruch 3, wobei der Licht empfangende Detektor (7) eine organische Fotodiode oder eine organische Kleinmolekül-Fotodiode umfasst.

6. Optischer Sensor nach Anspruch 1, wobei
- der Sensor zwei optische Elemente (3) umfasst, umfassend eine Licht emittierende Quelle (6) und einen Licht empfangenden Detektor (7), positioniert auf dem Substrat (2), welcher Detektor auf Licht (23), emittiert von der Quelle (6) reagiert, und
- wobei die Deformation (5) des Substrats (2) angeordnet ist, die Licht emittierende Quelle (6) oder den Licht empfangenden Detektor (7) zu neigen, um einen Lichtweg (26) für Licht (23) bereitzustellen, das sich von der Quelle (6) zu dem Detektor (7) bewegt, oder
wobei der optische Sensor eine erste Deformation (5), angeordnet um die Licht emittierende Quelle (6) zu neigen, und eine zweite Deformation (5), angeordnet um den Licht empfangenden Detektor (7) zu neigen, umfasst, um einen Lichtweg (26) für Licht (23), das sich von der Quelle (6) zu dem Detektor (7) bewegt, bereitzustellen.

7. Optischer Sensor nach Anspruch 6, wobei der Sensor ferner ein Licht leitendes Element (8) umfasst, welches Licht leitende Element (8) mindestens teilweise zwischen der Quelle (6) und dem Detektor (7) positioniert ist, wobei das Licht leitende Element (8) ein sensoraktives Material umfasst, das für die Menge Analyt in einer den Sensor umgebenden Flüssigkeit empfindlich ist.

8. Optischer Sensor nach Anspruch 7, wobei das sensoraktive Material die Licht leitenden Eigenschaften des Licht leitenden Elements (8) abhängig von der Menge Analyt in einer den Sensor umgebenden Flüssigkeit ändert.

9. Optischer Sensor nach Anspruch 8, wobei das sensoraktive Material die reflektiven Eigenschaften des Licht leitenden Elements (8) abhängig von der Menge Analyt in der den Sensor umgebenden Flüssigkeit ändert.

10. Optischer Sensor nach Anspruch 8, wobei die mindestens eine Licht emittierende Quelle (6) und der Licht empfangende Detektor (7) an das Licht leitende Element (8) anstoßen und wobei das sensoraktive Material die Form und/oder Größe des Licht leitenden Elements (8) abhängig von der Menge Analyt in der den Sensor umgebenden Flüssigkeit ändert, um einen Neigungswinkel der Licht emittierenden Quelle (6) und/oder des Licht empfangenden Detektors (7) zu ändern.

11. Optischer Sensor nach einem der Ansprüche 7-10, wobei das Licht leitende Element (8) ein fluidisches Transportsystem zum Transportieren des Analyten zu dem sensoraktiven Material umfasst.

12. Optischer Sensor nach Anspruch 6, wobei eine optische Oberfläche von mindestens einem von der Quelle (6) und dem Detektor (7) zu dem Substrat (2) gerichtet ist, das optisch wirksam ist.

13. Optischer Sensor nach Anspruch 12, wobei das optisch wirksame Substrat (2) einen Polarisationsfilter bildet.

14. Optischer Sensor nach Anspruch 13, wobei
- ein Licht leitendes Element (8) mindestens teilweise zwischen der Quelle (6) und dem Detektor (7) positioniert ist,
- das Licht leitende Element (8) lumineszierende Farbstoffe (32) umfasst, die Lumineszenzlicht (39) mit einer Zufallspolarisation emittieren, wenn optisch aktiviert, wobei die Merkmale des Lumineszenzlichts (39) von der Menge Analyt in der den Sensor umgebenden Flüssigkeit abhängen.

## Revendications

1. Capteur optique (1), le capteur comprenant :
- un substrat flexible (2),
- un élément optique (3) qui est positionné sur le substrat (2), le substrat flexible (2) comprenant une déformation (5) affectant l'élément optique (3),
- **caractérisé en ce que** la déformation (5) est agencée dans une zone de déformation de substrat (4) entourant au moins partiellement l'élément optique (3) le long d'un contour directement adjacent à l'élément optique (3) ; le contour s'étendant dans au moins deux directions différentes le long de l'élément optique (3).

2. Capteur optique selon la revendication 1, dans lequel la zone de déformation de substrat (4) est au moins partiellement affaiblie ou au moins partiellement déconnectée du substrat (2), de manière à faciliter la déformation du substrat (2).

3. Capteur optique selon la revendication 1, dans lequel l'élément optique (3) est un élément d'un groupe constitué d'une source d'émission de lumière (6), d'un détecteur de réception de lumière (7) et d'un élément de guidage de lumière (8).

4. Capteur optique selon la revendication 3, dans lequel la source d'émission de lumière (6) comprend une diode électroluminescente organique ou une diode électroluminescente organique à petites molécules.

5. Capteur optique selon la revendication 3, dans lequel le détecteur de réception de lumière (7) comprend une photodiode organique ou une photodiode organique à petites molécules.

6. Capteur optique selon la revendication 1, dans lequel
- le capteur comprend deux éléments optiques (3) comprenant une source d'émission de lumière (6) et un détecteur de réception de lumière (7) positionnés sur le substrat (2), le détecteur étant sensible à la lumière (23) émise par la source (6), et
- dans lequel la déformation (5) du substrat (2) est conçue pour incliner la source d'émission de lumière (6) ou le détecteur de réception de lumière (7) pour fournir un trajet de lumière (26) pour de la lumière (23) allant de la source (6) au détecteur (7), ou dans lequel le capteur optique comprend une première déformation (5) conçue pour incliner la source d'émission de lumière (6) et une seconde déformation (5) conçue pour incliner le détecteur de réception de lumière (7) pour fournir un trajet de lumière (23) pour de la lumière (23) allant de la source (6) au détecteur (7).

7. Capteur optique selon la revendication 6, dans lequel le capteur comprend en outre un élément de guidage de lumière (8), l'élément de guidage de lumière (8) étant positionné au moins partiellement entre la source (6) et le détecteur (7), dans lequel l'élément de guidage de lumière (8) comprend un matériau actif de capteur qui est sensible à la quantité d'analyte dans un fluide entourant le capteur.

8. Capteur optique selon la revendication 7, dans lequel le matériau actif de capteur modifie les propriétés de guidage de lumière de l'élément de guidage de lumière (8) en fonction de la quantité d'analyte dans un fluide entourant le capteur.

9. Capteur optique selon la revendication 8, dans lequel le matériau actif de capteur modifie les propriétés de réflexion de l'élément de guidage de lumière (8), en fonction de la quantité d'analyte dans le fluide entourant le capteur.

10. Capteur optique selon la revendication 8, dans lequel le au moins un élément parmi la source d'émission de lumière (6) et le détecteur de réception de lumière (7) vient en butée contre l'élément de guidage de lumière (8), et dans lequel le matériau actif de capteur change la forme et/ou la taille de l'élément de guidage de lumière (8) en fonction de la quantité d'analyte dans le fluide entourant le capteur, de manière à modifier un angle d'inclinaison de la source d'émission de lumière (6) et/ou du détecteur de réception de lumière (7).

11. Capteur optique selon l'une quelconque des revendications 7-10, dans lequel l'élément de guidage de lumière (8) comprend un système de transport fluidique pour transporter l'analyte vers le matériau actif de capteur.

12. Capteur optique selon la revendication 6, dans lequel une surface optique d'au moins un élément parmi la source (6) et le détecteur (7) est dirigée vers le substrat (2), qui est optiquement efficace.

13. Capteur optique selon la revendication 12, dans lequel le substrat optiquement efficace (2) forme un filtre de polarisation.

14. Capteur optique selon la revendication 13, dans lequel
- un élément de guidage de lumière (8) est positionné au moins partiellement entre la source (6) et le détecteur (7),
- l'élément de guidage de lumière (8) comprend des colorants luminescents (32) émettant une lumière luminescente (39) ayant une polarisation aléatoire lorsqu'ils sont activés optiquement, les caractéristiques de la lumière luminescente (39) étant fonction de la quantité d'analyte dans le fluide entourant le capteur.
